# EUROPÄISCHE PATENTSCHRIFT

(11) **EP 2 185 661 B1**
(45) Veröffentlichungstag und Bekanntmachung des Hinweises auf die Patenterteilung: **15.04.2015**
(21) Anmeldenummer: 08803268.5
(22) Anmeldetag: 27.08.2008
(51) Int. Cl.: C09D 5/24, C09D 125/18, C09D 165/00, H01B 1/12

(54) **VERFAHREN ZUR HERSTELLUNG VON LEITFÄHIGEN POLYMEREN**
PROCESS FOR PRODUCING CONDUCTING POLYMERS
PROCÉDÉ DE PRÉPARATION DE POLYMÈRES CONDUCTEURS

(30) Priorität: 04.09.2007 DE 102007041722
(43) Veröffentlichungstag der Anmeldung: 19.05.2010
(73) Patentinhaber: Heraeus Precious Metals GmbH & Co. KG, 63450 Hanau (DE)
(72) Erfinder: LOEVENICH, Wilfried, 51469 Bergisch Gladbach (DE); HILL, Rudolf, 40764 Langenfeld (DE); ELSCHNER, Andreas, 45479 Mühlheim (DE); JONAS, Friedrich, 52066 Aachen (DE); GUNTERMANN, Udo, 47800 Krefeld (DE)
(74) Vertreter: Herzog, Martin
(86) Internationale Anmeldenummer: PCT/EP2008/061213
(87) Internationale Veröffentlichungsnummer: WO 2009/030615

(56) Entgegenhaltungen:
- US-A1- 2007 085 061
- DATABASE CA [Online] CHEMICAL ABSTRACTS SERVICE, COLUMBUS, OHIO, US; 7. Dezember 2006 (2006-12-07), HIGUCHI, YASUSHI ET AL: ".pi.-conjugated conductive polymer solution for coatings" XP002504427 gefunden im STN Database accession no. 2006:1279517 in der Anmeldung erwähnt -& JP 2006 328276 A (SHIN-ETSU POLYMER CO., LTD., JAPAN) 7. Dezember 2006 (2006-12-07)

## Beschreibung

Die Erfindung betrifft ein neues Verfahren zur Herstellung von leitfähigen Polymeren in Gegenwart von Polyanionen, mit diesem Verfahren hergestellte wässrige oder nicht-wässrige Dispersionen oder Lösungen sowie deren Verwendung

Leitfähige Polymere gewinnen zunehmend an wirtschaftlicher Bedeutung, da Polymere gegenüber Metallen Vorteile bezüglich der Verarbeitbarkeit, des Gewichts und der gezielten Einstellung von Eigenschaften durch chemische Modifikation haben. Beispiele für bekannte n-konjugierte Polymere sind Polypyrrole, Polythiophene, Polyaniline, Polyacetylene, Polyphenylene und Poly(p-phenylen-vinylene). Schichten aus leitfähigen Polymeren werden technisch vielfältig eingesetzt, z.B. als polymere Gegenelektrode in Kondensatoren, als antistatische Beschichtung oder zur Durchkontaktierung von elektronischen Leiterplatten.

Die Herstellung leitfähiger Polymere erfolgt chemisch oder elektrochemisch oxidativ aus monomeren Vorstufen , wie z. B. gegebenenfalls substituierten Thiophenen, Pyrrolen und Anilinen und deren jeweiligen gegebenenfalls oligomeren Derivaten. Insbesondere die chemisch oxidative Polymerisation ist weit verbreitet, da sie technisch einfach in einem flüssigen Medium bzw. auf vielfältigen Substraten zu realisieren ist.

Ein besonders wichtiges und technisch genutztes Polythiophen ist das Poly(ethylen-3,4-dioxythiophen) (PEDOT oder PEDT), das durch chemische Polymerisation von Ethylen-3,4-dioxythiophen (EDOT oder EDT) hergestellt wird und das in seiner oxidierten Form sehr hohe Leitfähigkeiten aufweist und beispielsweise in der EP 339 340 A2 beschrieben ist. Eine Übersicht über zahlreiche Poly(alkylen-3,4-dioxythiophen)-Derivate, insbesondere Poly(ethylen-3,4-dioxythiophen)-Derivate, deren Monomerbausteine, Synthesen und Anwendungen geben L. Groenendaal, F. Jonas, D. Freitag, H. Pielartzik & J. R. Reynolds, Adv. Mater. 12, (2000) S. 481 - 494.

Besondere technische Bedeutung haben Dispersionen von PEDOT mit Polystyrolsulfonsäure (PSS) erlangt, wie sie beispielsweise in der EP 0440 957 offenbart sind. Aus diesen Dispersionen können transparente, leitfähige Filme erzeugt werden, die eine Vielzahl von Anwendungen gefunden haben. Allerdings ist die Leitfähigkeit der aus diesen Dispersionen erzeugten Schichten und die Transmission dieser Schichten noch zu niedrig, um beispielsweise Indium-Zinn-Oxid (ITO) in Touch-Screens oder organischen Leuchtdioden zu ersetzen. Schichten aus Indium-Zinn-Oxid (ITO) zeichnen sich zum Beispiel durch eine Leitfähigkeit von über 5000 S/cm aus und bei einer Transmission von 90 % werden Oberflächenwiderstände zwischen 5 und 20 Ohm pro Quadrat (Ohm/sq) erzielt.

J.Y.Kim et al. konnten zeigen, dass durch den Einsatz von polaren Hochsiedern die Leitfähigkeit eines PEDT/PSS-Films deutlich gesteigert werden kann. (J.Y.Kim et al., Synthetic Metals, 126, 2002, S. 311 - 316.) Durch den Zusatz von Dimethylsulfoxid (DMSO) zu einer PEDT/PSS Dispersion konnte die Leitfähigkeit um zwei Größenordnungen gesteigert werden, und zwar von 0,8 S/cm auf 80 S/cm. Der Einsatz von DMSO führt zu transparenten, leitfähigen Filmen ohne Trübung, so dass sich DMSO gut als Additiv zur Leitfähigkeitserhöhung eignet. Aber auch eine Leitfähigkeit von 80 S/cm ist noch nicht ausreichend, um beispielsweise Indium-Zinn-Oxid (ITO) in Touch-Screens oder Organischen Leuchtdioden zu ersetzen.

In JP 2006328276 wird die Leitfähigkeit einer PEDT/PSS-Dispersion durch den Einsatz von Succinimid gesteigert, wodurch Leitfähigkeiten von 200 - 1000 S/cm erreicht werden können. Succinimid eignet sich jedoch nur eingeschränkt zur Herstellung transparenter, leitfähiger Schichten, da es sich durch einen Schmelzpunkt von 123 - 135°C und einen Siedepunkt von 285 - 290°C auszeichnet. Bei üblichen Trocknungsbedingungen von 100 - 200°C verbleibt daher Succinimd im Gegensatz zum Dimethylsulfoxid im abschließenden leitfähigen Film und bildet dort kristalline Bereiche, was zu einer Trübung des Films führt. Der hohe Anteil an Succinimid führt daher zu einem Film. Daher ist auch diese Vorgehensweise nicht geeignet, transparente, hochleitfähige Schichten zu erzeugen.

In JP 2001323137 wird eine PEDT Synthese in Gegenwart von Polyanionen offenbart, welche unter Stickstoffatmosphäre durchgeführt wird.

In EP 1323764 und WO 03048227 wird beschrieben, dass die Polymerisation von EDT in Gegenwart von Polyanionen in einem sauerstoffarmen Medium zu einer verbesserten Leitfähigkeit des Reaktionsproduktes führt. Bei diesem Verfahren ist wichtig, dass die Sauerstoffkonzentration zum Zeitpunkt der Zugabe eines Initiators weniger als 3 mg/L Reaktionsmedium aufweist. Die Polymerisation wird dann unter Atmosphärendruck durchgeführt. Mit diesem Verfahren lassen sich leitfähige Filme herstellen, die Oberflächenwiderstände von 2900 Ohm/sq bis 1200 Ohm/cm erreichen. Diese Oberflächenwiderstände sind ebenfalls noch nicht ausreichend, um beispielsweise ITO in Touch-Screens oder organischen Leuchtdioden zu ersetzen.

Es bestand daher weiterhin Bedarf an Verfahren zur Herstellung leitfähiger Polymere, die eine hohe elektrische Leitfähigkeit und eine hohe Transparenz im sichtbaren Bereich aufweisen, und welche sich gut verarbeiten lassen.

Die Aufgabe der vorliegenden Erfindung bestand somit darin solche Verfahren bereitzustellen.

Überraschenderweise wurde nun gefunden, dass leitfähige Polymere die oben genannten Eigenschaften aufweisen, wenn das Verfahren zu ihrer Herstellung bei reduziertem Druck durchgeführt wird.

Gegenstand der vorliegenden Erfindung ist somit ein Verfahren gemäß Ansprüchen 1-7 zur Herstellung einer wässrigen oder nicht-wässrigen Dispersion oder Lösung enthaltend wenigstens ein leitfähiges Polymer und wenigstens ein Polyanion, dadurch gekennzeichnet, dass die Polymerisation bei einem Druck durchgeführt wird, welcher unter dem Atmosphärendruck liegt. Unter Atmosphärendruck wird hierbei der mittlere Luftdruck der Atmosphäre verstanden, welcher auf Meereshöhe 1013,25 Hectopascal (hPa) beträgt.

Das erfindungsgemäße Verfahren beruht darauf, dass vor dem Beginn der Polymerisation der Gesamtdruck im Reaktionsgefäß reduziert wird. Unter reduziertem Druck wird hierbei verstanden, dass der Druck im Reaktionsgefäß kleiner ist als der Atmosphärendruck, der außen am Reaktionsgefäß anliegt.

Leitfähige Polymere sind im Rahmen der Erfindung gegebenenfalls substituierte Polypyrrole, gegebenenfalls substituiertes Polyaniline oder gegebenenfalls substituierte Polythiophene sein. Es kann auch sein, dass Mischungen aus zwei oder mehreren dieser leitfähigen Polymere mit dem erfindungsgemäßen Verfahren hergestellt werden.

Besonders bevorzugte leitfähige Polymere sind gegebenenfalls substituierte Polythiophene enthaltend wiederkehrende Einheiten der allgemeinen Formel (I), 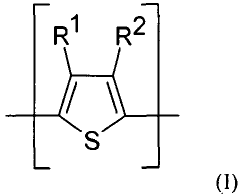 wobei
- R¹ und R²: unabhängig voneinander jeweils für H, einen gegebenenfalls substituierten C₁-C₁₈-Alkylrest oder einen gegebenenfalls substituierten C₁-C₁₈-Alkoxyrest, oder
- R¹ und R²: zusammen für einen gegebenenfalls substituierten C₁-C₈-Alkylenrest, worin ein oder mehrere C-Atom(e) durch ein oder mehrere gleiche oder unterschiedliche Heteroatome ausgewählt aus O oder S ersetzt sein können, bevorzugt einen C₁-C₈-Dioxyalkylenrest, einen gegebenenfalls substituierten C₁-C₈-Oxythiaalkylenrest oder einen gegebenenfalls substituierten C₁-C₈-Dithiaalkylenrest, oder für einen gegebenenfalls substituierten C₁-C₈-Alkylidenrest, worin gegebenenfalls wenigstens ein C-Atom durch ein Heteroatom ausgewählt aus O oder S ersetzt sein kann, stehen.

In bevorzugten Ausführungsformen sind Polythiophene enthaltend wiederkehrende Einheiten der allgemeinen Formel (I) solche enthaltend wiederkeherende Einheiten der allgemeinen Formel (I-a) und/oder der allgemeinen Formel (I-b) 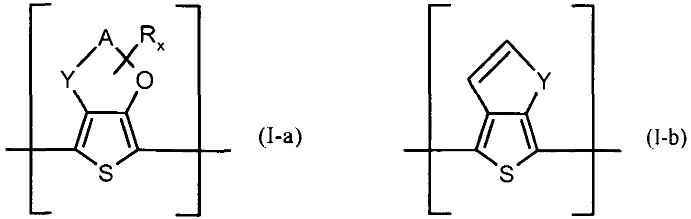 worin
- A: für einen gegebenenfalls substituierten C₁-C₅-Alkylenrest, bevorzugt für einen gegebenenfalls substituierten C₂-C₃-Alkylenrest steht,
- Y: für O oder S steht,
- R: für einen linearen oder verzweigten, gegebenenfalls substituierten C₁-C₁₈-Alkylrest, bevorzugt linearen oder verzweigten, gegebenenfalls substituierten C₁-C₁₄-Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
- x: für eine ganze Zahl von 0 bis 8, bevorzugt für 0, 1 oder 2, besonders bevorzugt für 0 oder 1, steht, und
für den Fall, dass mehrere Reste R an A gebunden sind, diese gleich oder unterschiedlich sein können.

Die allgemeine Formeln (1-a) ist so zu verstehen, dass der Substituent R x-mal an den Alkylenrest A gebunden sein kann.

In weiteren bevorzugten Ausführungsformen sind Polythiophene enthaltend wiederkehrende Einheiten der allgemeinen Formel (I) solche enthaltend wiederkehrende Einheiten der allgemeinen Formel (I-aa) und/oder der allgemeinen Formel (I-ab) 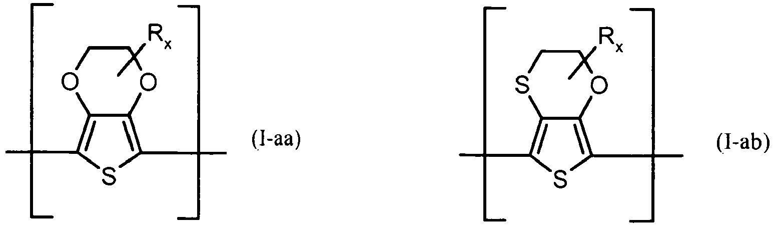 worin
R die oben genannte Bedeutung hat und x für eine ganze Zahl von 0 bis 4, bevorzugt für 0, 1 oder 2, besonders bevorzugt für 0 oder 1, steht.

Die allgemeinen Formeln (I-aa) und (I-ab) sind so zu verstehen, dass der Substituent R x-mal an den Ethylenrest gebunden sein kann.

In noch weiteren bevorzugten Ausführungsformen sind Polythiophene enthaltend wiederkehrende Einheiten der allgemeinen Formel (I) solche enthaltend Polythiophene der allgemeinen Formel (I-aaa) und/oder der allgemeinen Formel (1-aba)

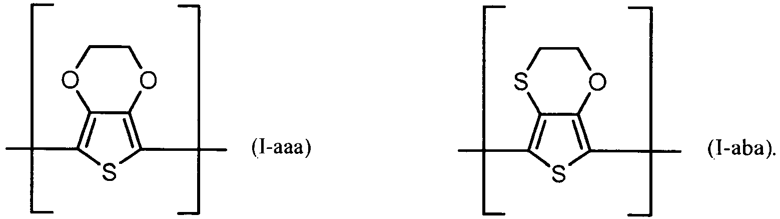

Unter dem Präfix Poly- ist im Rahmen der Erfindung zu verstehen, dass mehr als eine gleiche oder verschiedene wiederkehrende Einheit im Polythiophen enthalten ist. Die Polythiophene enthalten insgesamt n wiederkehrende Einheiten der allgemeinen Formel (I), wobei n eine ganze Zahl von 2 bis 2000, bevorzugt 2 bis 100, sein kann. Die wiederkehrenden Einheiten der allgemeinen Formel (I) können innerhalb eines Polythiophens jeweils gleich oder verschieden sein. Bevorzugt sind Polythiophene enthaltend jeweils gleiche wiederkehrende Einheiten der allgemeinen Formel (I).

An den Endgruppen tragen die Polythiophene bevorzugt jeweils H.

In besonders bevorzugten Ausführungsformen ist das Polythiophen mit wiederkehrenden Einheiten der allgemeinen Formel (I) Poly(3,4-ethylendioxythiophen), Poly(3,4-ethylenoxythiathiophen) oder Poly(thieno[3,4-b]thiophen, d.h. ein Homopolythiophen aus wiederkehrenden Einheiten der Formel (I-aaa), (I-aba) oder (I-b), wobei bei der Formel (I-b) Y in diesem Falle für S steht..

In weiteren besonders bevorzugten Ausführungsformen ist das Polythiophen mit wiederkehrenden Einheiten der allgemeinen Formel (I) ein Copolymer aus wiederkehrenden Einheiten der Formel (I-aaa) und (I-aba), (I-aaa) und (I-b), (I-aba) und (1-b) oder (I-aaa), (I-aba) und (I-b), wobei Copolymere aus wiederkehrenden Einheiten der Formel (I-aaa) und (I-aba) sowie (I-aaa) und (I-b) bevorzugt sind.

C₁-C₅-Alkylenreste A sind im Rahmen der Erfindung Methylen, Ethylen, n-Propylen, n-Butylen oder n-Pentylen, C₁-C₈-Alkylenreste darüber hinaus n-Hexylen, n-Heptylen und n-Oktylen. C₁-C₈-Alkylidenreste sind im Rahmen der Erfindung vorangehend aufgeführte C₁-C₈-Alkylenreste enthaltend wenigstens eine Doppelbindung. C₁-C₈-Dioxyalkylenreste, C₁-C₈-Oxythiaalkylenreste und C₁-C₈-Dithiaalkylenreste stehen im Rahmen der Erfindung für die den vorangehend aufgeführten C₁-C₈-Alkylenreste entsprechenden C₁-C₈-Dioxyalkylenreste, C₁-C₈-Oxythiaalkylenreste und C₁-C₈-Dithiaalkylenreste. C₁-C₁₈-Alkyl steht im Rahmen der Erfindung für lineare oder verzweigte C₁-C₁₈-Alkylreste wie beispielsweise Methyl, Ethyl, n- oder iso-Propyl, n-, iso-, sec- oder tert-Butyl, n-Pentyl, 1-Methylbutyl, 2-Methylbutyl, 3-Methylbutyl, 1-Ethylpropyl, 1,1-Dimethylpropyl, 1,2-Dimethylpropyl, 2,2-Dimethylpropyl, n-Hexyl, n-Heptyl, n-Octyl, 2-Ethylhexyl, n-Nonyl, n-Decyl, n-Undecyl, n-Dodecyl, n-Tridecyl, n-Tetradecyl, n-Hexadecyl oder n-Octadecyl, C₅-C₁₂-Cycloalkyl für C₅-C₁₂-Cycloalkylreste, wie Cyclopentyl, Cyclohexyl, Cycloheptyl, Cyclooctyl, Cyclononyl oder Cyclodecyl, C₆-C₁₄-Aryl für C₆-C₁₄-Arylreste wie Phenyl oder Naphthyl, und C₇-C₁₈-Aralkyl für C₇-C₁₈-Aralkylreste wie beispielsweise Benzyl, o-, m-, p-Tolyl, 2,3-, 2,4-, 2,5-, 2,6-, 3,4-, 3,5-Xylyl oder Mesityl. C₁-C₁₈-Alkoxyreste stehen im Rahmen der Erfindung für die den vorangehend aufgeführten C₁-C₁₈-Alkylresten entsprechenden Alkoxyreste. Die vorangehende Aufzählung dient der beispielhaften Erläuterung der Erfindung und ist nicht als abschließend zu betrachten.

Als gegebenenfalls weitere Substituenten der vorangehenden Reste kommen zahlreiche organische Gruppen in Frage, beispielsweise Alkyl-, Cycloalkyl-, Aryl-, Halogen-, Ether-, Thioether-, Disulfid-, Sulfoxid-, Sulfon-, Sulfonat-, Amino-, Aldehyd-, Keto-, Carbonsäureester-, Carbonsäure-, Carbonat-, Carboxylat-, Cyano-, Alkylsilan- und Alkoxysilangruppen sowie Carboxylamidgruppen.

Die oben genannten wässrigen Dispersionen oder Lösungen, bevorzugt enthaltend 3,4-Polyalkylendioxythiophene, können beispielsweise in Analogie zu dem in der EP 440 957 beschriebenen Verfahren hergestellt werden. Als Oxidationsmittel und Lösungsmittel kommen ebenfalls die in EP 440 957 aufgeführten in Frage. Unter einer wässrigen Dispersion oder Lösung wird im Rahmen dieser Erfindung eine Dispersion oder Lösung verstanden, die mindestens 50% Gewichtsprozent (Gew.-%) an Wasser, bevorzugt mindestens 90 Gew.-% an Wasser, enthält, und gegebenenfalls Lösungsmittel enthält, welche mit Wasser - zumindest teilweise - mischbar sind, wie Alkohole, z.B. Methanol, Ethanol, n-Propanol, Isopropanol, Butanol oder Octanol, Glykole oder Glykolether, z.B. Ethylenglykol, Diethylenglykol, Propan-1,2-diol, Propan-1,3-diol oder Dipropylenglykoldimethylether oder Ketone wie beispielsweise Aceton oder Methylethylketon. In der wässrigen Dispersion oder Lösung kann der Feststoffgehalt an gegebenenfalls substituierten Polythiophenen, insbesondere an gegebenenfalls substituierten Polythiophenen enthaltend wiederkehrende Einheiten der allgemeinen Formel (I), zwischen 0,05 und 3,0 Gewichtsprozent (Gew. %), bevorzugt zwischen 0,1 und 1,0 Gew.% liegen.

Verfahren zur Herstellung der monomeren Vorstufen für die Herstellung der Polythiophene der allgemeinen Formel (I) sowie deren Derivaten sind dem Fachmann bekannt und beispielsweise in L. Groenendaal, F. Jonas, D. Freitag, H. Pielartzik & J. R. Reynolds, Adv. Mater. 12 (2000) 481 - 494 und darin zitierter Literatur beschrieben.

Unter Derivaten der vorangehend aufgeführten Thiophene werden im Sinne der Erfindung beispielsweise Dimere oder Trimere dieser Thiophene verstanden. Es sind auch höhermolekulare Derivate, d.h. Tetramere, Pentamere etc. der monomeren Vorstufen als Derivate möglich. Die Derivate können sowohl aus gleichen wie unterschiedlichen Monomereinheiten aufgebaut sein und in reiner Form sowie im Gemisch untereinander und/oder mit den vorangehend genannten Thiophenen eingesetzt werden. Auch oxidierte oder reduzierte Formen dieser Thiophene und Thiophenderivate sind im Sinne der Erfindung von dem Begriff Thiophene und Thiophenderivate umfasst, sofern bei ihrer Polymerisation die gleichen leitfähigen Polymeren entstehen wie bei den vorangehend aufgeführten Thiophenen und Thiophenderivaten.

Die Thiophene können gegebenenfalls in Form von Lösungen eingesetzt werden. Als geeignete Lösungsmittel seien vor allem folgende unter den Reaktionsbedingungen inerte organische Lösungsmittel genannt: aliphatische Alkohole wie Methanol, Ethanol, i-Propanol und Butanol; aliphatische Ketone wie Aceton und Methylethylketon; aliphatische Carbonsäureester wie Essigsäureethylester und Essigsäurebutylester; aromatische Kohlenwasserstoffe wie Toluol und Xylol; aliphatische Kohlenwasserstoffe wie Hexan, Heptan und Cyclohexan; Chlorkohlenwasserstoffe wie Dichlormethan und Dichlorethan; aliphatische Nitrile wie Acetonitril, aliphatische Sulfoxide und Sulfone wie Dimethylsulfoxid und Sulfolan; aliphatische Carbonsäureamide wie Methylacetamid, Dimethylacetamid und Dimethylformamid; aliphatische und araliphatische Ether wie Diethylether und Anisol. Weiterhin kann auch Wasser oder ein Gemisch aus Wasser mit den vorgenannten organischen Lösungsmitteln als Lösungsmittel verwendet werden. Bevorzugte Lösungsmittel sind Alkohole und Wasser sowie Mischungen enthaltend Alkohole oder Wasser bzw. Mischungen aus Alkoholen und Wasser. Thiophene, die unter den Oxidationsbedingungen flüssig sind, können auch in Abwesenheit von Lösungsmitteln polymerisiert werden.

Die wässrige Dispersion oder Lösung kann zusätzlich wenigstens ein polymeres Bindemittel enthalten. Geeignete Bindemittel sind polymere, organische Binder, beispielsweise Polyvinylalkohole, Polyvinylpyrrolidone, Polyvinylchloride, Polyvinylacetate, Polyvinylbutyrate, Polyacrylsäureester, Polyacrylsäureamide, Polymethacrylsäureester, Polymethacryl-säureamide, Polyacrylnitrile, Styrol/Acrylsäureester-, Vinylacetat/Acrylsäureester- und Ethylen/Vinylacetat-Copolymerisate, Polybutadiene, Polyisoprene, Polystyrole, Polyether, Polyester, Polycarbonate, Polyurethane, Polyamide, Polyimide, Polysulfone, Melamin-Formaldehyharze, Epoxidharze, Siliconharze oder Cellulosen. Der Feststoffgehalt an polymerem Bindemittel liegt zwischen 0 und 3 Gew. %, bevorzugt zwischen 0 und 1 Gew. %.

Die Dispersion oder Lösung kann zusätzlich Haftvermittler, wie beispielsweise organofunktionelle Silane bzw. deren Hydrolysate, z.B. 3-Glycidoxypropyltrialkoxysilan, 3-Aminopropyl-triethoxysilan, 3-Mercaptopropyltrimethoxysilan, 3-Metacryloxypropyltrimethoxysilan, Vinyltrimethoxysilan oder Octyltriethoxysilan, enthalten.

Im Rahmen der Erfindung können die nicht-wässrigen Dispersionen oder Lösungen enthaltend wenigstens ein leitfähiges Polymer, bevorzugt gegebenenfalls substituierte Polythiophene, und wenigstens ein Polyanion in Analogie zu dem in der EP 1 373 356 offenbarten Verfahren hergestellt werden:
In einem ersten Verfahrensschritt werden wässrige oder nicht-wässrige Dispersionen oder Lösungen gemäß dem erfindungsgemäßen Verfahren hergestellt; in einem zweiten Verfahrensschritt wird zu dieser wässrigen Dispersion oder Lösung ein mit Wasser mischbares Lösungsmittel oder ein mit Wasser mischbares Lösungsmittelgemisch gegeben und dann wird das Wasser wenigstens zum Teil aus den resutierenden Mischungen entfernt und gegebenenfalls mit organischen Lösungsmitteln verdünnt. Als Lösungsmittel kommen hierbei amidische Lösungsmittel wie beispielsweise Formamid, N-Methylacelamid, N,N-Dimethylacetamid, N-Methylpyrroliodn, N-Methylcaprolactam oder N-Methylformamid, Alkohole und Ether wie beispielsweise Ethylenglykol, Glycerin, Ethylenglycoldimethylether, Ethylenglycolmonomethylether, Ethylenglycolmonobutylether oder Dioxan in Frage. Bevorzugt werden amidische Lösungsmittel und Lösungsmittel, die einen Siedepunkt von über 100°C bei Normaldruck besitzen und wassermischbare Lösungsmittel oder wassermischbare Lösungsmittelgemische, die mit Wasser ein Azeotrop bilden. Die Entfernung des Wassers kann beispielsweise durch Membranverfahren wie Ultrafiltration oder durch Destillation erfolgen. Falls eine Verdünnung mit organischen Lösungsmittel erfolgt, sind als Lösungsmittel die oben erwähnten Lösungsmittel und aliphatische Alkohole wie zum Beispiel Methanol, Ethanol, n-Propanol, isoPropanol, n-Butanol, iso-Butanol, tert-Butanol, Amylalkohol, iso-Amylalkohol, Neopentylakohol, Aliphatische Ketone wie beispielsweise Aceton, Methylethylketon, Methylisobutylketon, Methyltert.-butylketon, Ethyler wie zum Beispiel Tetrahydrofuran, Methyl-tert.-butylether, Ester aliphatischer und aromatischer Carbonsäuren wie zum Beispiel Essigsäureethylester, Essigsäurebutylester, Glycolmonomethyletheracetat, Phtalsäurebutylester oder aliphatische und aromatische Kohlenwassserstoffe wie Pentan, Hexan, Cyclohexan, Octan, iso-Octan, Decan, Toluol, o-Xylol, m-Xylol oder p-Xylol.

Die leitfähigen Polymere, insbesondere die Polythiophene, können neutral oder kationisch sein. In bevorzugten Ausführungsformen sind sie kationisch, wobei sich "kationisch" nur auf die Ladungen bezieht, die auf der Polythiophenhauptkette sitzen. Je nach Substituent an den Resten R können die Polythiophene positive und negative Ladungen in der Struktureinheit tragen, wobei sich die positiven Ladungen auf der Polythiophenhauptkette und die negativen Ladungen gegebenenfalls an den durch Sulfonat- oder Carboxylatgruppen substituierten Resten R befinden. Dabei können die positiven Ladungen der Polythiophenhauptkette zum Teil oder vollständig durch die gegebenenfalls vorhandenen anionischen Gruppen an den Resten R abgesättigt werden. Insgesamt betrachtet können die Polythiophene in diesen Fällen kationisch, neutral oder sogar anionisch sein. Dennoch werden sie im Rahmen der Erfindung alle als kationische Polythiophene betrachtet, da die positiven Ladungen auf der Polythiophenhauptkette maßgeblich sind. Die positiven Ladungen sind in den Formeln nicht dargestellt, da ihre genaue Zahl und Position nicht einwandfrei feststellbar sind. Die Anzahl der positiven Ladungen beträgt jedoch mindestens 1 und höchstens n, wobei n die Gesamtanzahl aller wiederkehrenden Einheiten (gleicher oder unterschiedlicher) innerhalb des Polythiophens ist.

Zur Kompensation der positiven Ladung, soweit dies nicht bereits durch die gegebenenfalls Sulfonat- oder Carboxylat-substituierten und somit negativ geladenen Reste R erfolgt, benötigen die kationischen Polythiophene Anionen als Gegenionen.

Als Gegenionen kommen monomere oder polymere Anionen, letztere im Folgenden auch als Polyanionen bezeichnet, in Frage.

Als monomere Anionen dienen beispielsweise solche von C₁-C₂₀-Alkansulfonsäuren, wie der Methan-, Ethan-, Propan-, Butan- oder höheren Sulfonsäuren, wie der Dodecansulfonsäure, von aliphatischen Perfluorsulfonsäuren, wie der Trifluormethansulfonsäure, der Perfluorbutansulfonsäure oder der Perfluoroctansulfonsäure, von aliphatischen C₁-C₂₀-Carbonsäuren wie der 2-Ethylhexylcarbonsäure, von aliphatischen Perfluorcarbonsäuren, wie der Trifluoressigsäure oder der Perfluoroctansäure, und von aromatischen, gegebenenfalls durch C₁-C₂₀-Alkylgruppen substituierten Sulfonsäuren wie der Benzolsulfonsäure, o-Toluolsulfonsäure, p-Toluolsulfonsäure, Dodecylbenzolsulfonsäure, Dinonylnaphthalinsulfonsäure oder Dinonylnaphthalindisulfonsäure, und von Cycloalkansulfonsäuren wie Camphersulfonsäure oder Tetrafluoroborate, Hexafluorophosphate, Perchlorate, Hexafluoroantimonate, Hexafluoroarsenate oder Hexachloroantimonate.

Besonders bevorzugt sind die Anionen der p-Toluolsulfonsäure, Methansulfonsäure oder Camphersulfonsäure.

Es können auch Anionen des verwendeten Oxidationsmittels oder aus diesem nach der Reduktion gebildete Anionen als Gegenionen dienen, so dass eine Zugabe zusätzlicher Gegenionen nicht zwingend erforderlich ist.

Verwendete polymere Anionen sind Anionen polymerer Carbonsäuren, wie Polyacrylsäuren, Polymethacrylsäuren oder Polymaleinsäuren, oder polymerer Sulfonsäuren, wie Polystyrolsulfonsäuren und Polyvinylsulfonsäuren. Diese Polycarbon- und -sulfonsäuren können auch Copolymere von Vinylcarbon- und Vinylsulfonsäuren mit anderen polymerisierbaren Monomeren, wie Acrylsäureestern und Styrol, sein. Diese können beispielsweise auch SO₃⁻M⁺- oder COO⁻M⁺-Gruppen enthaltende teilfluorierte oder perfluorierte Polymere sein, wobei M⁺ beispielsweise für, Li⁺, Na⁺, K⁺, Rb⁺, Cs⁺ oder NH₄⁺, bevorzugt für H⁺, Na⁺ oder K⁺ steht.

Besonders bevorzugt als polymeres Anion ist das Anion der Polystyrolsulfonsäure (PSS) als Gegenion.

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Kationische Polythiophene, die zur Ladungskompensation Anionen als Gegenionen enthalten, werden in der Fachwelt auch oft als Polythiophen/(Poly-)Anion-Komplexe bezeichnet.

In einer bevorzugten Ausführungsform der Erfindung wird die Polymerisation bei einem Druck durchgeführt, welcher unter 800 hPa liegt. In einer besonders bevorzugten Ausführungsform erfolgt die Polymerisation bei einem Druck, welcher unter 200 hPa liegt und in einer ganz besonders bevorzugten Ausführungsform wird die Polymerisation bei einem Druck durchgeführt, welcher unter 50 hPa liegt.

Die Polymerisation wird bevorzugt bei einer Temperatur in einem Bereich von 0 - 35°C, besonders bevorzugt bei einer Temperatur in einem Bereich von 5 - 25 °C und ganz besonders bevorzugt bei einer Temperatur in einem Bereich von 10 - 20°C durchgeführt.

Um die Leitfähigkeit der wässrigen oder nicht-wässrigen Dispersionen oder Lösungen zu steigern können im Rahmen der Erfindung leitfähigkeitssteigernde Mittel wie Dimethylsulfoxid dazugegeben werden. Aber auch andere leitfähigkeitssteigernde Mittel, wie in der EP 0686662 oder von Ouyang et al., Polymer, 45 (2004), S. 8443 - 8450 offenbart, können im Rahmen der Erfindung als leitfähigkeitssteigernde Mittel verwendet werden.

Ein weiterer Gegenstand der vorliegenden Offenbarung sind wässrige oder nicht-wässrige Dispersionen oder Lösungen, die nach dem erfindungsgemäßen Verfahren hergestellt werden sowie die Verwendung dieser wässrigen oder nicht-wässrigen Dispersionen oder Lösungen zur Herstellung leitfähiger Beschichtungen. Diese leitfähigen Beschichtungen können eine Leitfähigkeit von größer 500 S/cm aufweisen.

Noch ein weiterer Gegenstand der vorliegenden Offenbarung ist ein Verfahren zur Herstellung einer wässrigen oder nicht-wässrigen Dispersion oder Lösung enthaltend wenigstens ein leitfähiges Polymer und wenigstens ein Polyanion, dadurch gekennzeichnet, dass das Verfahren folgende Schritte umfasst:
1) Zugeben wenigstens eines Oxidationsmittels erst dann, wenn unter Zuhilfenahme von Inertgas das Reaktionsmedium inertisiert ist,
2) Durchführen der Polymerisation bei einem Druck, welcher unter dem Atmosphärendruck liegt.

Im Rahmen der Erfindung gilt das Reaktionsmedium als inertisiert, wenn das Inertgas für mindestens 5 Minuten, bevorzugt mindestens 20 Minuten durch das Reaktionsmedium geleitet wurde. Als Inertgas eignen sich beispielsweise Argon, Helium oder Stickstoff. Das Reaktionsmedium gilt ebenfalls als inertisiert, wenn der Innendruck des Reaktionsgefäßes mindestens einmal abgesenkt wurde und der Innendruck anschließend durch Zugabe von Inertgas erhöht wurde.

Dieses weitere erfindungsgemäße Verfahren umfasst alle für das erste genannte erfindungsgemäße Verfahren aufgeführten, allgemeinen oder in Vorzugsbereichen genannten Definitionen, Parameter Erläuterungen und Verfahrensbedingungen, insbesondere für wenigstens ein leitfähiges Polymer, wenigstens ein Polyanion und für den Druck, bei welchem die Polymerisation durchgeführt wird.

Ein noch weiterer Gegenstand der Offenbarung stellt eine wässrige oder nicht-wässrige Dispersion oder Lösung hergestellt nach dem weiteren erfindungsgemäßen Verfahren dar sowie die Verwendung dieser wässrigen oder nicht-wässrigen Dispersion oder Lösung zur Herstellung leitfähiger Beschichtungen. Diese leitfähigen Beschichtungen weisen eine Leitfähigkeit von mindestens 500 S/cm, bevorzugt von mindestens 600 S/cm, ganz besonders bevorzugt von mindestens 700 S/cm auf.

Die folgenden Beispiele dienen lediglich der beispielhaften Erläuterung der Erfindung und sind nicht als Beschränkung aufzufassen.

### Beispiele

### Beispiel 1: Herstellung einer PEDT:PSS Dispersion unter Einsatz von Stickstoffatmosphäre bei Atmosphärendruck (Vergleichsbeisniel)

Ein 3 L Edelstahlkessel wurde mit einem Rührer, einem Belüftungsventil am oberen Deckel, einem verschließbaren Materialeinlass am oberen Deckel, einem Belüftungsventil am Boden und einem Temperiermantel mit angeschlossenem Thermostat ausgerüstet. 2050 g Wasser, 500 g Polystyrolsulfonsäure-Lösung (5,0%ig) und 5,6 g einer 10%igen Eisen(III)-sulfatlösung wurden in das Reaktionsgefäß gegeben. Der Rührer drehte mit 50 Umdrehungen/Minute (U/min). Die Temperatur wurde auf 18°C eingestellt. Über das Belüftungsventil am Boden wurden für 3 Stunden (h) 200 l/h Stickstoff eingelassen, die über den geöffneten Materialeinlass entweichen konnten. Nach 3 h wurde der Stickstoffstrom am unteren Belüftungsventil abgestellt und es wurde ein Stickstoffstrom von 500 l/h am oberen Belüftungsventil eingestellt. Der Stickstoffstrom konnte über den Materialeinlass entweichen. Anschließend wurden im Stickstoffgegenstrom 10,13 g Ethylendioxythiophen (Baytron^{®} M V2, H.C. Starck GmbH, Goslar) mit Hilfe einer Spritze durch den Materialeinlass eingeführt. Anschließend wurden 23,7 g Natriumperoxodisulfat im Stickstoffgegenstrom über den Materialeinlass zugesetzt. Der Materialeinlass wurde geschlossen. Die Polymerisation wurde bei leichtem Stickstoffüberdruck von 20 hPa durchgeführt, um ein Eindringen von Atmosphärensauerstoff zu verhindern. Die Mischung wurde 23 h bei 18°C gerührt. Nach Abschluss der Reaktion wurde die Mischung in einen Kunststoffbecher überführt und zur Entfernung anorganischer Salze 500 ml eines Kationenaustauschers (Lewatit S100 H, Lanxess AG) und 290 ml eines Anionenaustauschers (Lewatit MP 62, Lanxess AG) zugegeben. Die Mischung wurde 6 h gerührt und der Ionenaustauscher wurde abfiltriert. Schließlich wurde die Mischung über einen 10 µm Filter gegeben. Die erhaltene Dispersion wies einen Feststoffgehalt von 1,19 % auf.

### Bestimmung der Leitfähigkeit:

19 g dieser Dispersion wurde mit 1 g Dimethylsulfoxid versetzt. Ein gereinigtes Glassubstrat wurde auf eine Lackschleuder gelegt und 10 ml der oben genannten Mischung wurden auf dem Substrat verteilt. Anschließend wurde die überstehende Lösung durch Rotation des Tellers abgeschleudert. Danach wurde das so beschichtete Substrat 15 min lang bei 130 °C auf einer Heizplatte getrocknet. Die Schichtdicke betrug 70 nm (Tencor, Alphastep 500).

Die Leitfähigkeit wurde bestimmt, indem über eine Schattenmaske Ag-Elektroden mit 2,5 cm Länge in einem Abstand von 10 mm aufgedampft werden. Der mit einem Elektrometer (Keithly 614) bestimmte Oberflächenwiderstand wurde mit der Schichtdicke multipliziert, um den elektrischen spezifischen Widerstand zu erhalten. Der spezifische Widerstand der Schicht lag bei 0,00265 Ohm·cm. Dies entspricht einer Leitfähigkeit von 377 S/cm. Die so hergestellten Schichten sind klar.

### Beispiel 2 (erfindungsgemäß): Herstellung einer PEDT:PSS Dispersion unter reduziertem Druck

Ein 3 L Edelstahlkessel wie unter Beispiel 1 beschrieben wurde eingesetzt. 2050 g Wasser, 500 g Polystyrolsulfonsäure-Lösung (5,0%ig) und 5,6 g einer 10%igen Eisen(III)-sulfatlösung wurden in das Reaktionsgefäß gegeben. Der Rührer drehte mit 50 U/min. Die Temperatur wurde auf 60°C eingestellt und der Innendruck im Kessel auf 100 hPa abgesenkt. Über 16 h wurde die Temperatur auf 18°C reduziert. Dadurch reduziert sich der Innendruck auf 33 hPa. Anschließend wurden im Stickstoffgegenstrom 10,13 g Ethylendioxythiophen (Baytron^{®} M V2, H.C. Starck GmbH, Goslar) über einen Schlauch in den Reaktionskessel eingesaugt. 23,7 g Natriumperoxodisulfat wurden in 50 g Wasser gelöst und ebenfalls über den Schlauch in das Reaktionsmedium gesaugt. Der Materialeinlass wurde geschlossen und der Innendruck des Reaktionsgefäßes auf 30hPa mit Hilfe der Vakuumpumpe eingestellt. Die Reaktion wurde nun für 23 h unter diesem reduzierten Druck durchgeführt. Nach Abschluss der Reaktion wurde das Reaktionsgefäß belüftet und die Mischung in einen Kunststoffbecher überführt und zur Entfernung anorganischer Salze 500 ml eines Kationenaustauschers (Lewatit S100 H, Lanxess AG) und 290 ml eines Anionenaustauschers (Lewatit MP 62, Lanxess AG) zugegeben. Die Mischung wurde 6 h gerührt und der Ionenaustauscher abfiltriert. Schließlich wurde die Mischung über einen 10 µm Filter gegeben. Die erhaltene Dispersion wies einen Feststoffgehalt von 1,26 % auf.

### Bestimmung der Leitfähigkeit:

19 g dieser Dispersion wurde mit 1 g Dimethylsulfoxid versetzt und wie im Beispiel 1 beschrieben wurden Schichten auf ein Glassubstrat gebracht, und es wurde die Leitfähigkeit gemessen. Der spezifische Widerstand der Schicht lag bei 0,00265 Ohm·cm. Dies entspricht einer Leitfähigkeit von 377 S/cm. Die so hergestellten Schichten sind klar.

### Bestimmung der Transmission

19 g dieser Dispersion wurde mit 1 g Dimethylsulfoxid versetzt. Ein gereinigtes Glassubstrat wurde auf eine Lackschleuder gelegt und 10 ml der oben genannten Mischung wurden auf dem Substrat verteilt. Anschließend wurde die überstehende Lösung durch Rotation des Tellers abgeschleudert. Danach wurde das so beschichtete Substrat 15 min lang bei 130 °C auf einer Heizplatte getrocknet. Die Schichtdicke betrug 110 nm (Tencor, Alphastep 500).

In einem Photometer (Lamba 900) wurde die Transmission der Schicht im Bereicht 320 - 780 nm bestimmt. Aus den Transmissionsdaten erfolgte die Berechnung des Normfarbwertes Y für die Lichtart D65/10°. Der Normalfarbwert wurde mit 86,52 bestimmt. Der Normalfarbwert des verwendeten Glassubstrates wurde mit 90,94 bestimmt.

### Beispiel 3 (erfindungsgemäß): Herstellung einer PEDT:PSS Dispersion unter reduziertem Druck unter Einsatz von Stickstoff zur Entgasung der Reaktionsmischung:

Ein 3 L Edelstahlkessel wie unter Beispiel 1 beschrieben wurde eingesetzt. 2050 g Wasser, 500 g Polystyrolsulfonsäure-Lösung (5,0%ig) und 5,6 g einer 10%igen Eisen(III)-sulfatlösung wurden in das Reaktionsgefäß gegeben. Der Rührer drehte mit 50 U/min. Die Temperatur wurde auf 18°C eingestellt. Über das Belüftungsventil am Boden wurden für 3 h 200 l/h Stickstoff eingelassen, die über den geöffneten Materialeinlass einweichen konnten. Nach 3 h wurde der Stickstoffstrom am unteren Belüftungsventil abgestellt und es wurde ein Stickstoffstrom von 500 l/ am oberen Belüftungsventil eingestellt. Der Stickstoffstrom konnte über den Materialeinlass entweichen. Anschließend wurden im Stickstoffgegenstrom 10,13 g Ethylendioxythiophen (Baytron^{®} M V2, H.C. Starck GmbH, Goslar) mit Hilfe einer Spritze durch den Materialeinlass eingeführt. Anschließend wurden 23,7 g Natriumperoxodisulfat im Stickstoffgegenstrom über den Materialeinlass zugesetzt. Der Materialeinlass wurde geschlossen und umgehend der Innendruck des Reaktionsgefäßes auf 30 hPa mit Hilfe einer Vakuumpumpe abgesenkt. Die Reaktion wurde nun für 23 h unter diesem reduzierten Druck durchgeführt. Nach Abschluss der Reaktion wurde das Reaktionsgefäß belüftet und die Mischung in einen Kunststoffbecher überführt und zur Entfernung anorganischer Salze 500 ml eines Kationenaustauschers (Lewatit S100 H, Lanxess AG) und 290 ml eines Anionenaustauschers (Lewatit MP 62, Lanxess AG) zugegeben. Die Mischung wurde 6 h gerührt und der Ionenaustauscher wurde abfiltriert. Schließlich wurde die Mischung über einen 10 µm Filter gegeben. Die erhaltene Dispersion wies einen Feststoffgehalt von 1,21 % auf.

### Bestimmung der Leitfähigkeit

19 g dieser Dispersion wurde mit 1 g Dimethylsulfoxid versetzt und wie im Beispiel 1 beschrieben wurden Schichten auf ein Glassubstrat gebracht, und es wurde die Leitfähigkeit gemessen. Der spezifische Widerstand der Schicht lag bei 0,00142 Ohm·cm. Dies entspricht einer Leitfähigkeit von 704 S/cm. Die so hergestellten Schichten sind klar.

### Bestimmung der Transmission

19 g dieser Dispersion wurde mit 1 g Dimethylsulfoxid versetzt. Ein gereinigtes Glassubstrat wurde auf eine Lackschleuder gelegt und 10 ml der oben genannten Mischung wurden auf dem Substrat verteilt. Anschließend wurde die überstehende Lösung durch Rotation des Tellers abgeschleudert. Danach wurde das so beschichtete Substrat 15 min lang bei 130 °C auf einer Heizplatte getrocknet. Die Schichtdicke betrug 60 nm (Tencor, Alphastep 500).

In einem Photometer (Lamba 900) wurde die Transmission der Schicht im Bereicht 320 - 780 nm bestimmt. Aus den Transmissionsdaten erfolgte die Berechnung des Normfarbwertes Y für die Lichtart D65/10°. Der Normalfarbwert wurde mit 87,21 bestimmt. Der Normalfarbwert des verwendeten Glassubstrates wurde mit 90,94 bestimmt.

### Beispiel 4: Herstellung einer PEDT:PSS Dispersion unter Normaldruck ohne den Einsatz von Stickstoff (Vergleichsbeispiel)

Ein 3 L Glasgefäß wurde mit einem Rührer ausgerüstet. 2050 g Wasser, 500 g Polystyrolsulfonsäure-Lösung (5,0%ig) und 5,6 g einer 10%igen Eisen(III)-sulfatlösung wurden in das Reaktionsgefäß gegeben. Der Rührer drehte mit 50 U/min. Die Temperatur wurde auf 18°C eingestellt. Anschließend wurden 10,13 g Ethylendioxythiophen (Baytron^{®} M V2, H.C. Starck GmbH, Goslar) zugesetzt. Anschließend wurden 23,7 g Natriumperoxodisulfat zugesetzt. Die Polymerisation wurde unter Normalatmosphäre durchgeführt. Die Mischung wurde 23 h bei 18°C gerührt. Nach Abschluss der Reaktion wurde die Mischung in einen Kunststoffbecher überführt und zur Entfernung anorganischer Salze 500 ml eines Kationenaustauschers (Lewatit S100 H, Lanxess AG) und 290 ml eines Anionenaustauschers (Lewatit MP 62, Lanxess AG) zugegeben. Die Mischung wurde 6 h gerührt und der Ionenaustauscher wurde abfiltriert. Schließlich wurde die Mischung über einen 10 µm Filter gegeben. Die erhaltene Dispersion wies einen Feststoffgehalt von 1,12 %.

### Bestimmung der Leitfähigkeit:

19 g dieser Dispersion wurde mit 1 g Dimethylsulfoxid versetzt und wie im Beispiel 1 beschrieben wurden Schichten auf ein Glassubstrat gebracht, und es wurde die Leitfähigkeit gemessen.

Der spezifische Widerstand der Schicht lag bei 0,00877 Ohm·cm. Dies entspricht einer Leitfähigkeit von 114 S/cm. Die so hergestellten Schichten sind klar.

### Beispiel 5 (erfindungsgemäß): Herstellung einer PEDT:PSS Dispersion unter vorgelagerte Zugabe von Oxidationsmittel und anschließender Synthese unter reduziertem Druck ohne den Einsatz von Stickstoff

Ein 3 L Edelstahlkessel wie unter Beispiel 1 beschrieben wurde eingesetzt. 2100 g Wasser, 500 g Polystyrolsulfonsäure-Lösung (5,0%ig), 5,6 g einer 10%igen Eisen(III)-sulfatlösung sowie 23,7 g Natriumperoxodisulfat wurden in das Reaktionsgefäß gegeben. Der Rührer drehte mit 50 U/min. Die Temperatur wurde auf 45°C eingestellt und der Innendruck im Kessel auf ca. 100 hPa abgesenkt. Über 1h wurde die Temperatur bei 45°C gehalten. Anschließend wurde die Temperatur auf 13°C abgesenkt. Dadurch sank der Druck auf ca. 25 hPa. Anschließend wurde die Apparatur belüftet und über den Materialeinlass wurden 10,13 g Ethylendioxythiophen (Baytron^{®} M V2, H.C. Starck GmbH, Goslar) zugesetzt. Der Materialeinlass wurde geschlossen und der Innendruck des Reaktionsgefäßes wurde erneut auf 30hPa mit Hilfe der Vakuumpumpe abgesenkt. Die Reaktion wurde nun für 23 h unter diesem reduzierten Druck bei 13°C durchgeführt. Nach Abschluss der Reaktion wurde das Reaktionsgefäß belüftet und die Mischung in einen Kunststoffbecher überführt und zur Entfernung anorganischer Salze 500 ml eines Kationenaustauschers (Lewatit S100 H, Lanxess AG) und 290 ml eines Anionenaustauschers (Lewatit MP 62, Lanxess AG) zugegeben. Die Mischung wurde 6 h gerührt und der Ionenaustauscher wurde abfiltriert. Schließlich wurde die Mischung über einen 10 µm Filter gegeben. Die erhaltene Dispersion wies einen Feststoffgehalt von 1,14 % auf.

### Bestimmung der Leitfähigkeit:

19 g dieser Dispersion wurde mit 1 g Dimethylsulfoxid versetzt und wie im Beispiel 1 beschrieben wurden Schichten auf ein Glassubstrat gebracht, und es wurde die Leitfähigkeit gemessen. Der spezifische Widerstand der Schicht lag bei 0,00192 Ohm·cm. Dies entspricht einer Leitfähigkeit von 520 S/cm. Die so hergestellten Schichten sind klar.

In Tabelle 1 wird ein Vergleich der Leitfähigkeiten der Schichten enthaltend Dispersionen hergestellt gemäß den Beispielen 1 bis 5 gezeigt.

**Tabelle 1:**

| Beispiel | Einsatz von Inertgas* | Druck | Leitfähigkeit [S/cm] |
|---|---|---|---|
| Beispiel 1 (Vergleichsbeispiel) | Ja | Atmosphärendruck | 377 |
| Beispiel 2 | Nein | Reduzierter Druck | 377 |
| Beispiel 3 | Ja | Reduzierter Druck | 704 |
| Beispiel 4 (Vergleichsbeispiel) | Nein | Atmosphärendruck | 114 |
| Beispiel 5 | Nein | Reduzierter Druck | 520 |

| | | | |
|---|---|---|---|
| * Der Einsatz von Inertgas erfolgt vor dem Polymerisationsbeginn. | | | |

Wie aus den Ergebnissen in Tabelle 1 ersichtlich ist, hängt die Leitfähigkeit der Schichten stark von dem Herstellungsverfahren für die leitfähigen Polymere. Es wird deutlich, dass die Polymerisation unter reduziertem Druck zu einer grundsätzlichen Verbesserung der Leitfähigkeit der hergestellten Schichten führt (s. Beispiel 2, 4 und 5). Wird die Polymerisation bei inerten Bedingungen und unter reduziertem Druck durchgeführt, so kann die Leitfähigkeit signifikant gesteigert werden wie aus Beispiel 3 ersichtlich ist.

## Patentansprüche

1. Verfahren zur Herstellung einer wässrigen oder nicht-wässrigen Dispersion oder Lösung enthaltend wenigstens ein leitfähiges Polymer ausgewählt aus der Gruppe bestehend aus einem gegebenenfalls substituierten Polypyrrol, einem gegebenenfalls substituierten Polyanilin und einem gegebenenfalls substituierten Polythiophen und wenigstens ein Polyanion ausgewählt aus der Gruppe bestehend aus einer polymeren Carbonsäure und einer polymeren Sulfonsäure, **dadurch gekennzeichnet, dass** die Polymerisation bei einem Druck durchgeführt wird, welcher unter dem Atmosphärendruck liegt.

2. Verfahren gemäß Anspruch 1, **dadurch gekennzeichnet, dass** wenigstens ein leitfähiges Polymer ein gegebenenfalls substituiertes Polythiophen enthaltend wiederkehrende Einheiten der allgemeinen Formel (I) 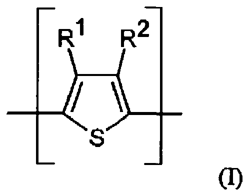 ist, wobei
R¹ und R² unabhängig voneinander jeweils für H, einen gegebenenfalls substituierten C₁-C₁₈-Alkylrest oder einen gegebenenfalls substituierten C₁-C₁₈-Alkoxyrest, oder
R¹ und R² zusammen für einen gegebenenfalls substituierten C₁-C₈-Alkylenrest, worin ein oder mehrere C-Atom(e) durch ein oder mehrere gleiche oder unterschiedliche Heteroatome ausgewählt aus O oder S ersetzt sein können, bevorzugt einen gegebenenfalls substituierten C₁-C₈-Oxythiaalkylenrest oder einen gegebenenfalls substituierten C₁-C₈-Dithiaalkylenrest, oder für einen gegebenenfalls substituierten C₁-C₈-Alkylidenrest, worin gegebenenfalls wenigstens ein C-Atom durch ein Heteroatom ausgewählt aus O oder S ersetzt sein kann, stehen.

3. Verfahren gemäß Anspruch 1 oder 2, **dadurch gekennzeichnet, dass** wenigstens ein leitfähiges Polymer ein Polythiophen enthaltend wiederkehrende Einheiten der allgemeinen Formel (I-aaa) und/oder der allgemeinen Formel (I-aba) 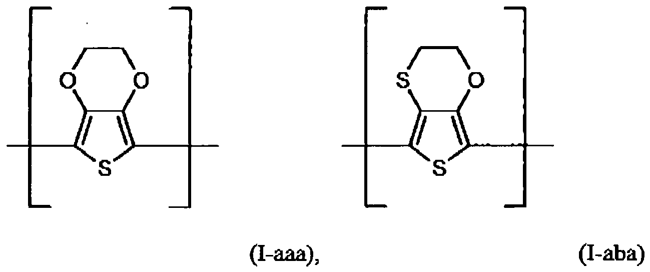 ist.

4. Verfahren gemäß wenigstens einem der Ansprüche 1 bis 3, **dadurch gekennzeichnet, dass** das Polyanion Polystyrolsulfonsäure ist.

5. Verfahren gemäß wenigstens einem der Ansprüche I bis 4, **dadurch gekennzeichnet, dass** die Polymerisation bei einem Druck durchgeführt wird, welcher unter 800 hPa liegt.

6. Verfahren gemäß wenigstens einem der Ansprüche 1 bis 5, **dadurch gekennzeichnet, dass** zu der wässrigen oder nicht-wässrigen Dispersion oder Lösung leitfähigkeitssteigernde Mittel gegeben werden.

7. Verfahren gemäß wenigstens einem der Ansprüche 1 bis 6, **dadurch gekennzeichnet, dass** das Verfahren folgenden Schritte umfasst:
1) Zugeben wenigstens eines Oxidationsmittels erst dann, wenn unter Zuhilfenahme von Inertgas das Reaktionsmedium inertisiert ist,

## Claims

1. Process for preparing an aqueous or non-aqueous dispersion or solution comprising at least one conductive polymer selected from the group consisting of an optionally substituted polypyrrole, an optionally substituted polyaniline and an optionally substituted polythiophene and at least one polyanion selected from the group consisting of a polymeric carboxylic acid and a polymeric sulphonic acid, **characterised in that** the polymerisation is carried out under a pressure which is below atmospheric pressure.

2. Process according to claim 1, **characterised in that** at least one conductive polymer is an optionally substituted polythiophene comprising recurring units of the general formula (I) 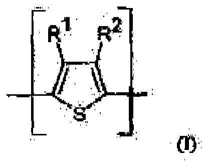 wherein
R¹ and R² independently of each other in each case represent H, an optionally substituted C₁-C₁₈-alkyl radical or an optionally substituted C₁-C₁₈-alkoxy radical, or R¹ and R² together represent an optionally substituted C₁-C₈-alkylene radical, wherein one or more C atom(s) can be replaced by one or more identical or different hetero atoms selected from O or S, preferably an optionally substituted C₁-C₈-oxythiaalkylene radical or an optionally substituted C₁-C₈-dithiaalkylene radical, or represent an optionally substituted C₁-C₈-alkylidene radical, wherein optionally at least one C atom can be replaced by a hetero atom selected from O or S.

3. Process according to claim 1 or 2, **characterised in that** at least one conductive polymer is a polythiophene comprising recurring units of the general formula (I-aaa) and/or of the general formula (I-aba)

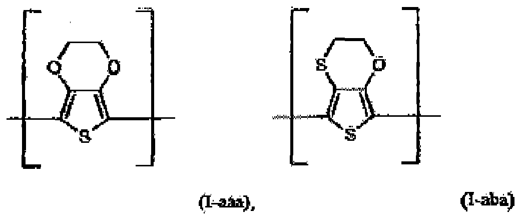

4. Process according to at least one of claims 1 to 3, **characterised in that** the polyanion is polystyrenesulphonic acid.

5. Process according to at least one of claims 1 to 4, **characterised in that** the polymerisation is carried out under a pressure which is below 800 hPa.

6. Process according to at least one of claims 1 to 5, **characterised in that** conductivity-increasing agents are added to the aqueous or non-aqueous dispersion or solution.

7. Process according to at least one of claims 1 to 6, **characterised in that** the process comprises the following steps:
1) adding at least one oxidising agent only when the reaction medium has been rendered inert with the aid of an inert gas.

## Revendications

1. Procédé de production d'une dispersion ou solution aqueuse ou non aqueuse comprenant au moins un polymère conducteur choisi dans le groupe constitué par un polypyrrol le cas échéant substitué, une polyaniline le cas échéant substituée et un polythiophène le cas échéant substitué et au moins un polyanion choisi dans le groupe constitué par un acide carboxylique polymère et un acide sulfonique polymère, **caractérisé en ce que** la polymérisation est réalisée à une pression qui se situe en dessous de la pression atmosphérique.

2. Procédé selon la revendication 1, **caractérisé en ce qu'**au moins un polymère conducteur est un polythiophène le cas échéant substitué, contenant des motifs répétitifs de formule générale (I) 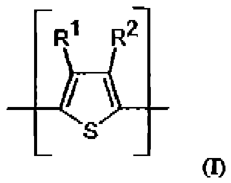 dans laquelle
R¹ et R² représentent, indépendamment l'un de l'autre, respectivement H, un radical alkyle en C₁-C₁₈ le cas échéant substitué ou un radical alcoxy en C₁-C₁₈ le cas échéant substitué, ou
R¹ et R² représentent conjointement un radical alkylène en C₁-C₈ le cas échéant substitué, dans lequel un ou plusieurs atomes de C peuvent être remplacés par un ou plusieurs hétéroatomes identiques ou différents choisis parmi O ou S, de préférence un radical oxythiaalkylène en C₁-C₈ le cas échéant substitué ou un radical dithiaalkylène en C₁-C₈ le cas échéant substitué, ou un radical alkylidène en C₁-C₈ le cas échéant substitué, dans lequel le cas échéant au moins un atome de C peut être remplacé par un hétéroatome choisi parmi O ou S.

3. Procédé selon la revendication 1 ou 2, **caractérisé en ce qu'**au moins un polymère conducteur est un polythiophène contenant des motifs répétitifs de formule générale (I-aaa) et/ou de formule générale (I-aba)

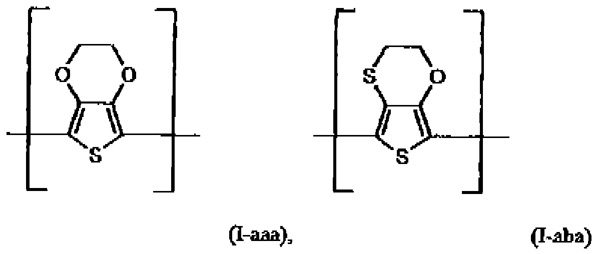

4. Procédé selon au moins une des revendications 1 à 3, **caractérisé en ce que** le polyanion est un acide polystyrènesulfonique.

5. Procédé selon au moins une des revendications 1 à 4, **caractérisé en ce que** la polymérisation est réalisée à une pression qui se situe en dessous de 800 hPa.

6. Procédé selon au moins une des revendications 1 à 5, **caractérisé en ce que** la dispersion ou solution aqueuse ou non aqueuse est additionnée d'agents augmentant la conductivité.

7. Procédé selon au moins une des revendications 1 à 6, **caractérisé en ce que** le procédé comprend l'étape suivante :
1) l'addition d'au moins un agent oxydant une fois que le milieu réactionnel est inertisé à l'aide de gaz inerte.
